# EUROPEAN PATENT APPLICATION

(11) **EP 3 863 385 A1**
(43) Date of publication of application: **11.08.2021**
(21) Application number: 21154934.0
(22) Date of filing: 03.02.2021
(51) Int. Cl.: H05K 1/09, H05K 1/11, H05K 3/12, H05K 1/02

(54) **PRINTED CIRCUIT BOARD AND METHOD OF MANUFACTURING PRINTED CIRCUIT BOARD**

(30) Priority: 04.02.2020 JP 2020017026
(71) Applicant: Yazaki Corporation, Minato-ku Tokyo 108-8333 (JP)
(72) Inventor: AOYAMA, Yukito, Susono-shi, Shizuoka 410-1194 (JP); SATO, Shota, Susono-shi, Shizuoka 410-1194 (JP); TONE, Rie, Susono-shi, Shizuoka 410-1194 (JP); TASHIRO, Kosuke, Susono-shi, Shizuoka 410-1194 (JP); YAMAGUCHI, Toshio, Susono-shi, Shizuoka 410-1194 (JP)
(74) Representative: Grünecker Patent- und Rechtsanwälte PartG mbB

(57) **Abstract**

A printed circuit board includes a substrate and wiring provided on a surface of the substrate and including a cured conductive paste. The conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin. The wiring has a width of 0.3 mm or more and 6 mm or less, a thickness of 10 µm or more and 40 µm or less, and a resistance value of 500 mQ/m or more and 5000 mQ/m or less, and a welding strength of the electronic component to the substrate is 30 N or more.

## Description

### TECHNICAL FIELD

The present invention relates to a printed circuit board and a method of manufacturing a printed circuit board.

### BACKGROUND

In recent years, a flexible printed wiring board (FPC) that can achieve miniaturization, thinning, and three-dimensionalization of a wire harness and peripheral parts thereof has been demanded in accordance with a reduction in a wiring space of a vehicle. In particular, for parts such as a center console and a map lamp, there is an increasing need for such a design that has a curved surface shape, and there is an increasing need for an FPC that can be freely arranged even in a narrow space. Furthermore, in printed wiring boards of parts such as the center console and the map lamp, since a power supply circuit provided on a rigid substrate and a sensor circuit provided on a flexible substrate are mixed, there is an increasing need for the FPC in which these circuits are provided on one substrate. In addition, since it is necessary to mount electronic components in such an FPC, there is an increasing need for a printed circuit board equipped with these.

As an FPC that responds to demands for miniaturization, thinning, and three-dimensionalization, there is known an FPC in which an electric circuit is formed by bonding a thin and soft base film with electrical insulation and a conductive metal such as copper foil. The circuit of the FPC is usually manufactured by a method called a subtractive method. For example, a circuit can be formed by bonding a metal foil such as copper to a polyimide film and etching the metal foil. Such a subtractive method requires complicated and very long processes such as photolithography, etching, and chemical vapor deposition, and thereby there is a problem in that a throughput is very low. Further, in the processes such as photolithography and etching, problems relating to the environment such as waste liquid are regarded as problems.

In order to solve the above-describe problems, an additive method, in the reverse of the subtractive method, in which a conductor pattern is formed on an insulating plate is examined. There are a plurality of kinds of the additive methods, and examples thereof include plating; printing a conductive paste or the like; depositing metal on a necessary part of a substrate; wiring a cable sheathed with polyimide on a substrate; and adhering a previously formed pattern to a substrate.

Among these additive methods, a printing method is exemplified as a method in which the throughput is the highest. In the printing method, an electric circuit is established by mainly using a film as a substrate, further using a conductive paste as a conductive wire material, and combining an insulating film, a resist, or the like therewith. Such a conductive paste includes a metal component, an organic solvent, a reducing agent, a resin component, and a wiring is formed by calcining after coating to enable conduction.

JP 2013-134914 A discloses a conductive composition containing a thermoplastic resin and a thermosetting resin as a binder resin, a curing agent, and metal particles. WO 2017/033911 A discloses a metal paste obtained by kneading a solid content including silver particles and a solvent. A metal paste contains a predetermined amount of silver particles of which a particle diameter of 100 to 200 nm, and the average particle diameter of the whole silver particles is 60 to 800 nm, and as an additive, high molecular weight ethyl cellulose having a number average molecular weight in a predetermined range.

JP 2013-142173 A discloses that a silver compound and a predetermined amine mixture are mixed to form a complex compound containing the silver compound and the amine, and the complex compound is heated and thermally decomposed to form silver nanoparticles. In addition, JP 2013-142173 A discloses a silver coating composition containing the silver nanoparticles and an organic solvent. JP 2000-239636 A discloses a curable conductive paste containing an epoxy resin, a curing agent, conductive powder, and a solvent. JP 2012-84440 A discloses a thermosetting conductive paste containing (A) a conductive filler, (B) a thermosetting binder, (C) a cellulose resin, and (D) an acrylonitrile-butadiene copolymer if necessary.

### SUMMARY

Although the conductive paste contains a resin component in order to make the wiring adhere to the substrate, if the wiring contains a large amount of resin component, solder wettability at the time of bonding an electronic component is lowered, and a bonding strength of the electronic component to the wiring may be reduced. Since a general resin component has low conductivity, an electrical resistance value of the wiring obtained from the conductive paste is approximately several to several tens of times larger than that of the copper foil. In particular, in a conductive paste mainly composed of micro-sized metal particles, the resistance value of the wiring may increase because there are few contact points between the metal particles. It is difficult to increase the film thickness of the wiring obtained from the conductive paste, and the film thickness of the wiring is often about several micrometres. In particular, in a conductive paste mainly composed of nano-sized metal particles, it is difficult to increase the film thickness of the wiring. Therefore, even if a conductive paste of the prior art is used, it is difficult to obtain a printed circuit board in which the resistance of the wiring is small, adhesion of the wiring to the substrate can be increased, and the bonding strength of the electronic component to the wiring can be increased.

The present invention has been made in view of the problems in the related art. An object of the present invention is to provide a printed circuit board in which resistance of wiring is small, adhesion of the wiring to a substrate can be increased, and a bonding strength of an electronic component to the wiring can be increased.

The printed circuit board according to an aspect of the present invention includes a substrate, wiring provided on a surface of the substrate and including a cured conductive paste containing metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin, and an electronic component connected to the substrate via the wiring. In this printed circuit board, the wiring has a width of 0.3 mm or more and 6 mm or less, a thickness of 10 µm or more and 40 µm or less, and a resistance value of 500 mQ/m or more and 5000 mQ/m or less, and a welding strength of the electronic component to the substrate is 30 N or more.

The thermosetting resin having the oxirane ring in the molecule may be at least one selected from the group consisting of a bisphenol A type epoxy resin, a bisphenol F type epoxy resin, a novolac type epoxy resin, a glycidylamine type epoxy resin, and an aliphatic type epoxy resin.

The average particle diameter of the metal particles may be 1 µm or more and 5 µm or less.

The wiring may be provided on both surfaces of the substrate.

The substrate has a curved surface, and the wiring may be provided on the curved surface.

A method of manufacturing a printed circuit board according to another aspect of the present invention includes applying a conductive paste to a surface of a substrate, and curing the applied conductive paste to form wiring. In this manufacturing method, the conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin, the wiring has a width of 0.3 mm or more and 6 mm or less, a thickness of 10 µm or more and 40 µm or less, and a resistance value of 500 mΩ/m or more and 5000 mΩ/m or less, and a welding strength of the electronic component to the substrate is 30 N or more.

According to the present disclosure, it is possible to provide a printed circuit board in which resistance of wiring is small, adhesion of the wiring to a substrate can be increased, and a bonding strength of an electronic component to the wiring can be increased.

### BRIEF DESCRIPTION OF THE DRAWINGS

FIG. 1 is a plan view illustrating an example of a printed wiring board; and
FIG. 2 is a plan view illustrating the printed wiring board produced in an example.

### DETAILED DESCRIPTION

Hereinafter, a printed wiring board, a printed circuit board, and methods of manufacturing the printed wiring board and the printed circuit board according to the present embodiment will be described in detail with reference to the drawings. The dimensional ratios in the drawings are exaggerated for convenience of explanation, and some of the ratios are different from actual ones.

### [Printed wiring board]

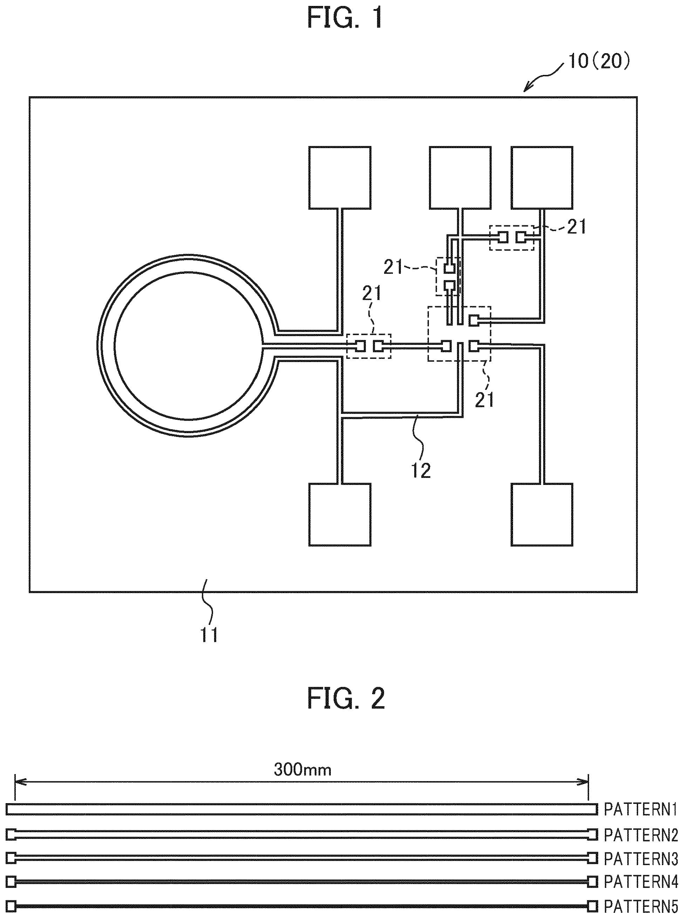

First, the printed wiring board according to the present embodiment will be described. As shown in FIG. 1, a printed circuit board 20 includes a printed wiring board 10 and an electronic component 21. The printed wiring board 10 includes a substrate 11 and wiring 12.

### (Substrate)

The substrate 11 that can be used for the printed wiring board 10 is not particularly limited, and an electrically insulating film or a plate material can be used. Such a substrate 11 is flexible and can be bent or the like depending on the portion to be used. The material of the substrate 11 is not particularly limited, for example, it is possible to use at least one selected from the group consisting of polyimide (PI), polyethylene terephthalate (PET), polyethylene naphthalate (PEN), polycarbonate (PC), polypropylene (PP), and polybutylene terephthalate (PBT).

### (Wiring)

The wiring 12 is provided on a surface of the substrate 11. The wiring 12 has a width of 0.3 mm or more and 6 mm or less, a thickness of 10 µm or more and 40 µm or less, and a resistance value of 500 mQ/m or more and 5000 mQ/m or less. The width, thickness, and resistance value of the wiring 12 may be the same or different depending on the position of the wiring 12. For example, when the printed wiring board 10 has a sensor circuit and a power supply circuit, an amount of current flowing through the wiring of the power supply circuit tends to be larger than that of the sensor circuit. Therefore, the width of the wiring of the power supply circuit may be made wider than the width of the wiring of the sensor circuit.

The width of the wiring 12 is 0.3 mm or more and 6 mm or less. Since the width of the wiring 12 is 0.3 mm or more, it is suppressed that the resistance value of the wiring 12 becomes too high. Furthermore, since the width of the wiring 12 is 6 mm or less, the wiring 12 can be arranged even in a narrow space, so that space saving can be promoted. The width of the wiring 12 may be 0.6 mm or more, or 1.0 mm or more. Furthermore, the width of the wiring 12 may be 2.0 mm or less, or 1.5 mm or less.

The thickness of the wiring 12 is 10 µm or more and 40 µm or less. As described above, it is difficult to increase the film thickness of the wiring obtained from a conventional conductive paste, and the film thickness of the wiring is often about several micrometres. In particular, in the conventional conductive paste mainly composed of nano-sized metal particles, it is difficult to increase the film thickness of the wiring. However, according to the conductive paste described later, the thickness of the wiring 12 can be 10 µm or more. Since the thickness of the wiring 12 is 10 µm or more, it is suppressed that the resistance value of the wiring 12 becomes too high. When the thickness of the wiring 12 is 40 µm or less, flexibility of the printed wiring board 10 can be increased. Furthermore, when the thickness of the wiring 12 is 40 µm or less, it becomes easy to sheath the wiring 12 with an insulating cover. The thickness of the wiring 12 may be 15 µm or more, or 20 µm or more. Furthermore, the thickness of the wiring 12 may be 30 µm or less, or 25 µm or less.

The length of the wiring 12 may be 100 mm or more and 1600 mm or less. When the length of the wiring 12 is 100 mm or more, the wiring 12 can be applied to large circuit wiring for vehicle applications and the like. Furthermore, when the length of the wiring 12 is 1600 mm or less, it is less necessary to apply a high voltage to the wiring 12, and it is easy to apply the wiring 12 to vehicle applications and the like. The length of the wiring 12 may be 200 mm or more, or 400 mm or more. Furthermore, the length of the wiring 12 may be 1000 mm or less, or 600 mm or less.

The resistance value of the wiring 12 is 500 mQ/m or more and 5000 mQ/m or less. Although the wiring obtained from the conventional conductive paste has a width of 0.3 mm or more and 6 mm or less and a thickness of 10 µm or more and 40 µm or less, it is difficult to set the resistance value of the wiring to 5000 mΩ/m or less. However, according to the conductive paste described later, the resistance value of the wiring 12 can be set to 5000 mQ/m or less. Since the resistance value of the wiring 12 is 5000 mQ/m or less, even when a current of 1 A is passed through the wiring 12, heat generation of the wiring 12 is 10°C or lower, so that the wiring 12 can be applied to automobile applications and the like.

The wiring 12 is made by curing the conductive paste. The wiring 12 may contain metal nanoparticles, metal particles, a first resin, and a second resin. The wiring 12 is a conductor made by curing the conductive paste. As will be described later, the conductive paste contains metal nanoparticles, metal particles, a thermosetting resin, a curing agent, and a cellulose resin. In the present embodiment, since the wiring 12 has such a composition, adhesion of the wiring 12 to the substrate 11 can be increased, and a bonding strength of the electronic component 21 to the wiring 12 can be increased.

### (Metal nanoparticles)

Metal nanoparticles have an average particle diameter of 30 nm or more and 600 nm or less. Since the metal nanoparticles have such an average particle diameter, a gap between the metal particles can be filled with the metal nanoparticles, and a dense sintered body is formed, so that conductivity of the wiring 12 can be improved. Note that, the average particle diameter of the metal nanoparticles is more preferably 70 nm or more and 600 nm or less from the viewpoint of forming a denser sintered body and increasing the conductivity. The average particle diameter of the metal nanoparticles can be measured by observing the metal nanoparticles with a scanning electron microscope.

The metal constituting the metal nanoparticle is not particularly limited, and is preferable to contain at least one selected from the group consisting of gold, silver, copper, platinum, palladium, rhodium, ruthenium, iridium, osmium, tungsten, nickel, tantalum, bismuth, lead, indium, tin, zinc, and titanium. Further, the metal constituting the metal nanoparticle more preferably consists of at least one selected from the group consisting of gold, silver, copper, platinum, palladium, rhodium, ruthenium, iridium, osmium, tungsten, nickel, tantalum, bismuth, lead, indium, tin, zinc, and titanium. Furthermore, it is preferable that the metal consisting of a metal nanoparticle contains at least one selected from the group consisting of gold, silver, copper, and platinum. By using such metal nanoparticles, fine wiring 12 can be formed. In addition, by using metal nanoparticles such as these, the resistance value of the wiring 12 can be reduced, and surface smoothness of the wiring 12 can be improved. Among these metals, it is preferable to use silver as the metal nanoparticles from the viewpoint of reducing the resistance value of the wiring 12.

The content of the metal nanoparticles in the wiring 12 may be 10% by mass or more, 20% by mass or more, or 30% by mass or more. Furthermore, the content of the metal nanoparticles in the wiring 12 may be 50% by mass or less, or 40% by mass or less.

### (Metal particles)

Metal particles have an average particle diameter larger than that of metal nanoparticles. By using such metal particles, the wiring 12 can be densified, and the resistance value of the wiring 12 can be reduced.

The average particle diameter of the metal particles is preferably 1 µm or more and 5 µm or less. When the average particle diameter of the metal particles is within this range, the conductivity of the wiring 12 can be increased. The average particle diameter of the metal particles can be measured by observing the metal particles with a scanning electron microscope.

Similar to the metal nanoparticle, the metal constituting the metal particle is preferable to contain at least one selected from the group consisting of gold, silver, copper, platinum, palladium, rhodium, ruthenium, iridium, osmium, tungsten, nickel, tantalum, bismuth, lead, indium, tin, zinc, and titanium. Further, the metal constituting the metal particle more preferably consists of at least one selected from the group consisting of gold, silver, copper, platinum, palladium, rhodium, ruthenium, iridium, osmium, tungsten, nickel, tantalum, bismuth, lead, indium, tin, zinc, and titanium. Furthermore, it is preferable that the metal consisting of a metal particle contains at least one selected from the group consisting of gold, silver, copper, and platinum. By using metal particles including of these metals, the resistance value of the wiring 12 can be reduced, and the surface smoothness of the wiring 12 can be improved. Among these metals, it is preferable to use silver as the metal particles from the viewpoint of reducing specific resistance of the wiring 12.

The content of the metal particles in the wiring 12 may be 10% by mass or more, 20% by mass or more, or 30% by mass or more. Furthermore, the content of the metal particles in the wiring 12 may be 50% by mass or less, or 40% by mass or less.

The ratio of the metal nanoparticles to the metal particles is not particularly limited, and is preferably, for example, 1:9 or more and 9:1 or less by mass ratio. When the ratio of the metal nanoparticles to the metal particles is within this range, the wiring 12 made of a dense sintered body and having improved conductivity can be obtained. In addition, in a case where the ratio of the metal nanoparticles is lower than this range, it may become difficult to satisfy the specific resistance of the wiring 12 to be obtained. On the other hand, when the ratio of the metal nanoparticles is higher than this range, the viscosity of the conductive paste is lowered, and it may be difficult to satisfy the workability.

A ratio of a total content of the metal nanoparticles to the metal particles in the wiring 12 may be 80% by mass or more, 85% by mass or more, or 90% by mass or more. The ratio of the total content of the metal nanoparticles to the metal particles in the wiring 12 may be 99.9% by mass or less, 99% by mass or less, or 98% by mass or less.

### (First resin)

The first resin is a resin produced by reacting molecules having an oxirane ring with each other. Oxirane is 3-membered ring ether that is also called ethylene oxide. By using such molecules, adhesion between the substrate 11 and the wiring 12 can be improved.

The molecule having an oxirane ring is not particularly limited, and is preferably at least one selected from the group consisting of a bisphenol A type epoxy resin, a bisphenol F type epoxy resin, a novolac type epoxy resin, a glycidylamine type epoxy resin, and an aliphatic type epoxy resin.

The content of the first resin in the wiring 12 may be 0.1% by mass or more, or 1% by mass or more. Furthermore, the content of the first resin in the wiring 12 may be 10% by mass or less, or 5% by mass or less.

### (Second resin)

The second resin is a cellulose resin. By uniformly dispersing the cellulose resin in the conductive paste, it is possible to suppress the fluidity of the conductive paste from increasing and the printability of the conductive paste from decreasing. Moreover, since the thermosetting resin and the curing agent are entangled with each other by uniformly dispersing the cellulose resin in the conductive paste, the adhesion between the wiring 12 formed by calcining the conductive paste and the substrate 11 can be improved.

Examples of the cellulose resin include cellulose ether, cellulose ester, and cellulose ether ester, and it is preferable to use cellulose ether. Examples of the cellulose ether include cellulose single ether in which one kind of ether group is bonded to cellulose and cellulose mixed ether in which two or more kinds of ether groups are bonded to cellulose. Specific examples of the cellulose single ether include methyl cellulose, ethyl cellulose, propyl cellulose, hydroxymethyl cellulose, hydroxyethyl cellulose, hydroxypropyl cellulose, and carboxymethyl cellulose. Specific examples of the cellulose mixed ether include methyl ethyl cellulose, methyl propyl cellulose, ethyl propyl cellulose, hydroxymethyl ethyl cellulose, hydroxypropyl methyl cellulose, hydroxyethyl methyl cellulose, and hydroxypropyl methyl cellulose. The cellulose ether may be used alone and may be used in combination of two or more kinds thereof. Note that, a cellulose resin is preferably ethyl cellulose.

The content of the cellulose resin in the wiring 12 may be 0.1% by mass or more, or 0.5% by mass or more. Furthermore, the content of the cellulose resin in the wiring 12 may be 5% by mass or less, or 3% by mass or less.

The wiring 12 may be provided on both surfaces of the substrate 11. That is, the substrate 11 may have a first surface and a second surface opposite to the first surface, and the wiring 12 may be provided on the first surface and the second surface. According to such a printed wiring board 10, it is possible to provide a complicated circuit.

The substrate 11 has a curved surface, and the wiring 12 may be provided on the curved surface. Such a printed wiring board 10 can be applied to a component having a curved surface shape, and can provide a center console or a map lamp having a curved surface shape with a high design property.

### (Insulating cover material)

The printed wiring board 10 provided with the wiring 12 may include an insulating cover material for covering and protecting the surface of the wiring 12. An insulating film or a resist can be used as the insulating cover material. As the insulating cover material, it is preferable to use polyimide (PI), polyethylene terephthalate (PET), polyethylene naphthalate (PEN), polycarbonate (PC), polypropylene (PP), polybutylene terephthalate (PBT), polyurethane (PU), and the like with an adhesive on one side. In addition, the resist is preferably a thermosetting resist or a UV curable resist, and particularly preferably an epoxy resist or a urethane resist.

As described above, the printed wiring board 10 includes the substrate 11 and the wiring 12 provided on the surface of the substrate 11 and including the cured conductive paste. The conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin. The wiring 12 has a width of 0.3 mm or more and 6 mm or less, a thickness of 10 µm or more and 40 µm or less, and a resistance value of 500 mQ/m or more and 5000 mΩ/m or less, and a welding strength of the electronic component 21 to the substrate 11 is 30 N or more.

As described above, the wiring 12 obtained by printing and curing the conventional conductive paste has a resistance value approximately several to several tens of times larger than that of a copper foil, and the film thickness of the wiring 12 is also often about several micrometres. Such a printed wiring board is often applied to a circuit that only passes a current of about several tens of mA. On the other hand, in the printed wiring board 10 according to the present embodiment, since the resistance of the wiring 12 is small, it is possible to pass a current of 1 A that can be realized with a copper foil having a width of 1 mm and a thickness of 35 µm. Since the wiring 12 contains the above-described material, the adhesion of the wiring 12 to the substrate 11 is high, and the bonding strength of the electronic component 21 to the wiring 12 is high. Therefore, in the printed wiring board 10, the resistance of the wiring 12 is small, and it is possible to increase the welding strength of the electronic component 21 to the substrate 11. Consequently, the power supply circuit, which requires low-resistance wiring, and the sensor circuit, which requires the electronic component to be mounted for control, can be formed on a flexible substrate with one type of conductive paste in one printing. Therefore, it is possible to satisfy required functions with a single flexible printed wiring board without separately providing a rigid substrate for control. Therefore, the printed wiring board 10 according to the present embodiment can also be applied to an automobile component such as a center console or a map lamp.

### [Printed circuit board]

Next, the printed circuit board according to the present embodiment will be described. The printed circuit board 20 according to the present embodiment includes the printed wiring board 10 and the electronic component 21 connected to the substrate 11 of the printed wiring board 10 via the wiring 12.

### (Electronic component)

As the electronic component 21, a known component that can be used in an electronic circuit can be used. The electronic component 21 may be, for example, an active component such as an integrated circuit, a transistor or a diode, a passive component such as a resistor or a capacitor, or a combination thereof.

The welding strength of the electronic component 21 to the substrate 11 is 30 N or more. When the welding strength is 30 N or more, it is possible to prevent the electronic component 21 from being detached from the printed wiring board 10 even when the printed circuit board 20 is conveyed and deformed. The welding strength may be 50 N or more, or 100 N or more. The upper limit of the welding strength is not particularly limited, and may be 1000 N or less, or 500 N or less.

### [Method of manufacturing printed wiring board]

Next, a method of manufacturing the printed wiring board 10 will be described. The method of manufacturing the printed wiring board 10 according to the present embodiment includes a step of applying a conductive paste to the surface of the substrate 11 and a step of curing the applied conductive paste to form the wiring 12.

### (Conductive paste)

The conductive paste contains metal nanoparticles, metal particles, a thermosetting resin, a curing agent, and a cellulose resin.

### (Metal nanoparticles)

As the metal nanoparticles, the above-described materials can be used. The conductive paste contains metal nanoparticles having an average particle diameter of 30 nm or more and 600 nm or less. Usually, a metal melting point decreases because the number of metal atoms present on the particle surface increases as the diameter of the metal particle decreases. Therefore, it is possible to form the wiring 12 at a relatively low temperature by using such metal nanoparticles for the conductive paste. Further, when the average particle diameter of the metal nanoparticles is 30 nm or more and 600 nm or less, a gap between the metal particles can be filled with the metal nanoparticles. Therefore, since the metal nanoparticles and the metal particles are sintered to form a dense sintered body, the conductivity of the wiring 12 obtained by calcining the conductive paste can be increased. Note that, the average particle diameter of the metal nanoparticles is more preferably 70 nm or more and 600 nm or less from the viewpoint of forming a denser sintered body and increasing the conductivity.

### (Metal particles)

As the metal particles, the above-described materials can be used. Metal particles have an average particle diameter larger than that of metal nanoparticles. By using such metal particles, the wiring 12 can be densified, and the resistance value of the wiring 12 can be reduced. The average particle diameter of the metal particles is preferably 1 µm or more and 5 µm or less. When the average particle diameter of the metal particles is within this range, the conductivity of the wiring 12 can be increased. In addition, as described later, even in a case where the conductive paste is applied to the insulating substrate 11 by a screen printing method, a fine circuit can be efficiently formed due to little possibility of clogging metal particles in the screen printing mesh.

### (Thermosetting resin)

The conductive paste according to the present embodiment contains a thermosetting resin having an oxirane ring in the molecule. By using such a thermosetting resin, in when the wiring 12 is formed by applying and curing the conductive paste to the substrate 11, the adhesion between the substrate 11 and the wiring 12 can be improved.

The thermosetting resin having an oxirane ring in the molecule is not particularly limited, and is preferably at least one selected from the group consisting of a bisphenol A type epoxy resin, a bisphenol F type epoxy resin, a novolac type epoxy resin, a glycidylamine type epoxy resin, and an aliphatic type epoxy resin.

### (Curing agent)

The curing agent is not particularly limited as long as the thermosetting resin contained in the conductive paste can be cured. For example, an imidazole curing agent, an amide curing agent, a phenol curing agent, an amine curing agent, an acid anhydride curing agent, or the like can be used for the curing agent. The curing agent may be used alone and may be used in combination of two or more kinds thereof.

Examples of the imidazole curing agent include imidazole, 2-methylimidazole, 2-ethylimidazole, 2-ethyl-4-methylimidazole, 2-isopropylimidazole, 2-phenylimidazole, 1-cyanoethyl-2-undecylimidazole, 1-cyano-2-phenylimidazole, 1-cyanoethyl-2-undecylimidazole trimellitate, and 1-cyanoethyl-2-phenylimidazolium trimellitate.

Examples of the amide curing agent include dicyandiamide.

Examples of the phenol curing agent include a phenol resin.

Examples of the amine curing agent include aliphatic amines such as diethylenetriamine, triethylenetetramine, tetraethylenepentamine, and N-aminoethylpiperazine, and aromatic amines such as toluenediamine, xylenediamine, diaminodiphenylmethane, phenylenediamine, and diaminodiphenylsulfone.

Examples of the acid anhydride curing agent include phthalic anhydride, trimellitic anhydride, tetrahydrophthalic anhydride, methyltetrahydrophthalic anhydride, methylhexahydrophthalic anhydride, hexahydrophthalic anhydride, and nadic anhydride.

The curing agent is preferably a 5-membered heterocyclic aromatic compound containing nitrogen. The 5-membered heterocyclic aromatic compound containing nitrogen is a heterocyclic compound containing carbon and nitrogen, having a 5-membered ring, and having aromaticity. Since such a curing agent generally has a curing start temperature of 100°C or higher, even when a conductive paste is prepared and applied to the substrate 11 or the like, curing does not easily start at room temperature, and the curing is easy to start after calcining. Therefore, when the printed wiring board 10 is manufactured, the conductive paste can be easily handled. As the curing agent of the 5-membered heterocyclic aromatic compound containing nitrogen, the imidazole curing agent is mentioned, for example.

The content ratio of the thermosetting resin to the curing agent is preferably 1:1 or more and 4:1 or less by mass ratio. By setting the content ratio of the thermosetting resin to the curing agent to be within the above range, the reactivity between the thermosetting resin and the curing agent is further improved, so that the curing of the conductive paste can be promoted. Note that, the content ratio of the thermosetting resin to the curing agent is more preferably 1:1 or more and 3:1 or less by mass ratio.

### (Cellulose resin)

The conductive paste contains a cellulose resin. By uniformly dispersing the cellulose resin in the conductive paste, it is possible to suppress the fluidity of the conductive paste from increasing and the printability of the conductive paste from decreasing. Moreover, since the thermosetting resin and the curing agent are entangled with each other by uniformly dispersing the cellulose resin in the conductive paste, the adhesion between the wiring 12 formed by calcining the conductive paste and the substrate 11 can be improved.

Although the content of the cellulose resin in the conductive paste is not particularly limited, it is preferable to prepare so that the printability of a conductive paste may become favorable. Specifically, the content of the cellulose resin is preferably 0.1% by mass or more and 4% by mass or less with respect to the entire conductive paste. When the content of the cellulose resin is 0.1% by mass or more, the adhesion between the wiring 12 formed by calcining the conductive paste and the substrate 11 can be further improved. Moreover, when content of a cellulose resin is 4% by mass or less, the fluidity of the conductive paste can be prevented from excessively rising, and the printability of the conductive paste can be improved. Further, when the content of the cellulose resin is 4% by mass or less, the content of the relative metal component in the wiring 12 increases, so that the conductivity of the wiring 12 can be improved. The content of the cellulose resin is more preferably 0.1% by mass or more and 2% by mass or less with respect to the entire conductive paste.

### (Organic solvent)

The conductive paste of the present embodiment may contain an organic solvent in order to uniformly disperse the metal nanoparticles, metal particles, a thermosetting resin, a curing agent, and a cellulose resin. The organic solvent is not particularly limited as long as it can highly disperse the metal nanoparticles and metal particles and dissolve the thermosetting resin, the curing agent, and the cellulose resin.

As the organic solvent, it is preferable to use an organic solvent having 8 or more and 16 or less carbon atoms in total, a hydroxyl group, and a boiling point of 280°C or lower. Specifically, as the organic solvent, it is possible to use at least one selected from the group consisting of diethylene glycol monoethyl ether acetate (C8, boiling point of 218°C), terpineol (C10, boiling point of 219°C), dihydroterpineol (C10, boiling point of 220°C), texanol (C12, boiling point of 260°C), 2,4-dimethyl-1,5-pentadiol (C9, boiling point of 150°C), and butyl carbitol (C8, boiling point of 230°C). In addition, as the organic solvent, it is also possible to use at least one selected from the group consisting of isophorone (boiling point of 215°C), ethylene glycol (boiling point of 197°C), butyl carbitol acetate (boiling point of 247°C), and 2,2,4-trimethyl-1,3-pentanediol diisobutyrate (C16, boiling point of 280°C).

The additional amount of the organic solvent in the conductive paste is not particularly limited, and it is preferable to prepare the viscosity so that the conductive paste can be applied by a screen printing method or the like. Specifically, the content of the organic solvent is preferably 10% by mass or more and 25% by mass or less with respect to the entire conductive paste.

The conductive paste of the present embodiment may contain additives such as an antifoaming agent, a surfactant, a rheology modifier to improve printing characteristics and conductor characteristics within a range that does not adversely affect the dispersion stability of the paste and the performance of the wiring 12 after calcining.

As described above, the conductive paste includes a metal component such as metal nanoparticles and metal particles, and a resin component such as a thermosetting resin, a curing agent, and a cellulose resin. Then, the wiring 12 is formed by calcining after applying the conductive paste to the substrate 11. At this time, it is preferable to add a certain amount of a resin component to the conductive paste in order to improve the adhesion between the obtained wiring 12 and the substrate 11.

Here, a solder is easy to bond with metal, while being difficult to bond with resin. For this reason, the resin component may reduce the wettability between the wiring 12 and the solder during mounting, thereby making it difficult to form a fillet shape or forming a solder ball. In such a case, a bonding strength between the wiring 12 and the mounted component may not be satisfied.

From such a viewpoint, the total content of the thermosetting resin and the curing agent is preferably 0.1% by mass or more and 6% by mass or less with respect to the entire conductive paste. When the total content is 0.1% by mass or more, the adhesion between the wiring 12 formed by calcining the conductive paste and the substrate 11 can be further improved. Further, when the total content is 6% by mass or less, the content of the relative metal component in the wiring 12 increases, so that the conductivity of the wiring 12 can be improved.

In addition, the total content of the thermosetting resin and the curing agent is more preferably 0.1% by mass or more and 5% by mass or less, further preferably 0.1% by mass or more and 4% by mass or less, and is particularly preferably 0.1% by mass or more and 2% by mass or less, with respect to the entire conductive paste. By setting the total content of the thermosetting resin and the curing agent within this range, the resin component in the obtained wiring 12 is reduced, so that the wettability of the solder to the wiring 12 can be improved. That is, by reducing the resin component in the entire conductive paste, the metal nanoparticles and the metal particles are easily brought into contact with each other, and sintering is promoted, so that the pores are reduced in a size to obtain the wiring 12 having a high metal concentration. Such a wiring 12 makes it possible to satisfy contradictory characteristics such as adhesion to the substrate 11 and wettability of solder. In addition, since such a wiring 12 has a small amount of flux that appears on the surface after calcining, the excellent solder wettability is possible.

A method of applying the conductive paste on the substrate 11 is not particularly limited, and can be performed by a conventionally known method such as flexographic printing, gravure printing, gravure offset printing, offset printing, screen printing, rotary screen printing, dispense printing, letterpress printing, or inkjet printing.

A calcining method after applying the conductive paste on the substrate 11 is also not specifically limited. For example, it is preferable to expose the substrate 11 coated with the conductive paste to hot air of 140°C or higher. With this, since the organic solvent or the like in the conductive paste is removed and the metal nanoparticles and the metal particles are sintered, the wiring 12 having high conductivity can be obtained. It is more preferable to expose the substrate 11 coated with the conductive paste to hot air of 250°C or higher. By raising the calcining temperature, the obtained sintered body becomes denser, and therefore it is possible to further reduce the resistance. Note that, the calcining method is not limited to the above-described hot-air calcining, and for example, plasma calcining, light calcining, and pulse wave calcining can also be applied.

### [Method of manufacturing printed circuit board]

The printed circuit board 20 is obtained by mounting the electronic component 21 on the printed wiring board 10. The method of mounting the electronic component 21 on the printed wiring board 10 is not particularly limited, and the electronic component 21 may be connected to the substrate 11 of the printed wiring board 10 via the wiring 12 by, for example, soldering.

### [Example]

Hereinafter, the present disclosure will be described in more detail with reference to examples and comparative examples, but the present disclosure is not limited to these examples.

### [Preparation of conductive paste]

First, a conductive paste of each example was prepared by stirring metal nanoparticles, metal particles, the first resin, a curing agent, the second resin, and an organic solvent at a compounding ratio indicated in Tables 1 to 6 using a rotation and revolution stirrer. The materials used as raw materials of the conductive pastes of each example are as follows.

### (Metal nanoparticles)

Silver nanoparticles having average particle diameters of 25 nm, 30 nm, 70 nm, 350 nm, 600 nm, and 700 nm

### (Metal particles)

Silver particles having average particle diameters of 1.0 µm, 3.0 µm, and 5.0 µm

### (First resin)

- Bisphenol A type epoxy resin, jER (registered trademark) 828, manufactured by Mitsubishi Chemical Corporation
- Bisphenol F type epoxy resin, EPICLON (registered trademark) 830, manufactured by DIC Corporation
- Aliphatic epoxy resin, PG-207GS (polypropylene glycol diglycidyl ether) manufactured by NIPPON STEEL Chemical & Material Co., Ltd.
- Novolac type epoxy resin, YDPN-638 (phenol Novolac type epoxy resin), manufactured by NIPPON STEEL Chemical & Material Co., Ltd.
- Phenolic resin, PS-2608, manufactured by Gun Ei Chemical Industry Co., Ltd.
- Urethane resin, UREARNO (registered trademark) KL-422, manufactured by Arakawa Chemical Industries, Ltd.

### (Curing agent)

- Dicyandiamide, DICY7, manufactured by Mitsubishi Chemical Corporation
- Imidazole, NISSOCURE (registered trademark) TIC-188, manufactured by Nippon Soda Co., Ltd.
- Hexamethylenetetramine, manufactured by Mitsubishi Gas Chemical Company, Inc.
- Polyisocyanate, BURNOCK (registered trademark) D-750, manufactured by DIC Corporation

### (Second resin)

- Hydroxyethylmethylcellulose, METOLOSE (registered trademark) SEB04T, manufactured by Shin-Etsu Chemical Co., Ltd.
- Ethyl cellulose, ETHOCEL (registered trademark) STD4, manufactured by The Dow Chemical Company
- Ethyl cellulose acrylic polymer, ACRIT (registered trademark) KWE-250T, manufactured by Taisei Fine Chemical Co., Ltd.
- Polyamide, F-915, manufactured by Tokyo Printing Ink Mfg. Co., Ltd.
- Acrylic resin, ACRYDIC (registered trademark) 52-204, manufactured by DIC Corporation

### (Organic solvent)

- Terpineol, manufactured by Tokyo Chemical Industry Co., Ltd.
- Diethylene glycol monoethyl ether acetate, manufactured by Tokyo Chemical Industry Co., Ltd.
- Texanol (2,2,4-trimethylpentane-1,3-diol monoisobutyrate) manufactured by Eastman Chemical Company

### [Evaluation]

The conductive paste of each example was evaluated as follows. These results are indicated in Tables 1 to 6.

### (Specific resistance of wiring)

The specific resistance of the wiring was measured in accordance with JIS K7194. As a device, a four-probe resistance measuring instrument (resistivity measuring device Sigma-5 + manufactured by NPS Corporation) was used.

Specifically, first, wiring was printed with the conductive paste obtained in each example on a substrate of a polyimide film using a screen printer so that the width was 1 mm, the length was 10 cm, and the thickness was 30 µm after calcining. Next, after the substrate on which the wiring was printed was allowed to stand at room temperature for 30 minutes, it was calcined with hot air at 140°C for 30 minutes to produce a printed wiring board.

Next, the surface resistance of the obtained Ag thin film on the printed wiring board was measured at three points, 1 cm portions from both ends and a 5 cm portion at the center. Note that, the surface resistance was measured with the needle placed parallel to the wiring.

### (Adhesion)

The adhesion of the conductive paste to the substrate was evaluated by a peeling test using a tape having an adhesive force of 3.9 N/10 mm or more and 5.7 N/10 mm or less.

Specifically, first, wiring was printed with the conductive paste obtained in each example on a substrate using a screen printer so that the width was 1 mm, the length was 10 cm, and the thickness was 30 µm after calcining. After the substrate on which the wiring was printed was allowed to stand at room temperature for 30 minutes, it was calcined with hot air at 140°C for 30 minutes to produce a printed wiring board.

Next, the adhesive surface of the tape was pressure-bonded to the obtained printed wiring board with fingers so that no bubbles remained, and after about 10 seconds, the tape was quickly peeled off in a direction perpendicular to the printed surface. As a tape, an aluminum tape No. 950, manufactured by Nichiban Co., Ltd., with an adhesive force of 5.30 N/10 mm was used.

### • Criteria

A: No print peeling is observed (a case where the peeled wiring cannot be checked on the tape side and a case where the peeling of the wiring cannot be checked visually on the printed wiring board side)
B: Print peeling is observed (a case where the peeled wiring can be checked on the tape side or a case where the peeling of the wiring can be checked visually on the printed wiring board side)

**[Table 1]**

| | Details of materials | Example 1-1 | Example 1-2 | Example 1-3 | Example 1-4 | Example 1-5 |
|---|---|---|---|---|---|---|
| Silver nanoparticle (part(s) by mass) | 25nm | - | - | - | - | - |
| | 30nm | - | | | - | |
| | 70nm | 40 | - | | 20 | - |
| | 350nm | - | 40 | - | - | 30 |
| | 600nm | | - | 40 | | - |
| | 700nm | - | | - | - | |
| Silver particle (part(s) by mass) | 1.0*µ*m | 40 | - | | 60 | - |
| | 3.0*µ* m | - | 40 | - | - | 50 |
| | 5.0*µ* m | - | - | 40 | - | - |
| First resin (part(s) by mass) | Bisphenol A type epoxy resin | 0.1 | - | - | - | - |
| | Bisphenol F type epoxy resin | - | 3 | - | - | - |
| | Aliphatic epoxy resin | | - | 3.2 | - | - |
| | Novolac type epoxy resin | - | - | - | 1.5 | 2.4 |
| | Phenolic resin | - | - | - | - | - |
| | Urethane resin | - | - | - | - | - |
| Curing agent (part(s) by mass) | Dicyandiamide | 0.1 | - | 0.8 | - | - |
| | Imidazole | - | 1 | - | 0.75 | 0.8 |
| | Hexamethylenetetramine | - | - | - | - | - |
| | Polvisocvanate | - | | - | - | - |
| Second resin (part(s) by mass) | Hydroxyethylmethylcellulose | 0.1 | - | 4 | - | - |
| | Ethyl cellulose | - | 2 | - | - | 3 |
| | Ethyl cellulose acrylic polymer | - | - | - | 2 | - |
| | Polyamide | - | - | - | - | - |
| | Acrylic resin | - | - | - | - | - |
| Organic solvent (part(s) by mass) | Terpineol | 19.7 | - | - | 15.75 | - |
| | Diethylene glycol monoethyl ether acetate | - | 14 | - | - | 13.8 |
| | Texanol | - | - | 12 | - | - |
| Characteristics | Specific resistance (Ω·cm) | 3.1×10⁻⁶ | 4.5×10⁻⁶ | 4.2×10⁻⁶ | 4.2×10⁻⁶ | 4.9×10⁻⁶ |
| | Adhesion | A | A | A | A | A |

**[Table 2]**

| | Details of materials | Example 1-6 | Example 1-7 | Example 1-8 | Example 1-9 | Example 1-10 |
|---|---|---|---|---|---|---|
| Silver nanoparticle (part(s) by mass) | 25nm | - | - | - | - | - |
| | 30nm | - | - | - | 10 | 35 |
| | 70nm | - | 55 | - | - | - |
| | 350nm | - | - | 65 | - | - |
| | 600nm | 50 | - | - | - | - |
| | 700nm | - | - | - | - | - |
| Silver particle (part(s) by mass) | 1.0*µ*m | - | - | 20 | 70 | 45 |
| | 3.0*µ* m | - | 20 | - | - | - |
| | 5.0*µ*m | 30 | - | - | - | - |
| First resin (part(s) by mass) | Bisphenol A type epoxy resin | - | - | 0.5 | - | - |
| | Bisphenol F type epoxy resin | - | 2 | - | 0.1 | - |
| | Aliphatic epoxy resin | 1 | - | - | - | - |
| | Novolac type epoxy resin | - | - | - | - | 0.1 |
| | Phenolic resin | - | - | - | - | - |
| | Urethane resin | - | - | - | - | - |
| Curing agent (part(s) by mass) | Dicyandiamide | - | 1 | 0.5 | - | - |
| | Imidazole | 1 | - | - | 0.1 | 0.1 |
| | Hexamethylenetetramine | - | - | - | - | - |
| | Polvisocvanate | - | - | - | - | - |
| Second resin (part(s) by mass) | Hydroxyethylmethylcellulose | - | - | - | - | - |
| | Ethyl cellulose | - | - | 2 | 1 | 1 |
| | Ethyl cellulose acrylic polymer | 1.5 | 1 | 1 | - | - |
| | Polyamide | - | - | - | - | - |
| | Acrylic resin | - | - | - | - | - |
| Organic solvent (part(s) by mass) | Terpineol | - | 21 | 11 | - | - |
| | Diethylene glycol monoethyl ether acetate | - | - | - | - | - |
| | Texanol | 16.5 | - | - | 18.8 | 18.8 |
| Characteristics | Specific resistance (Ω·cm) | 3.5×10⁻⁶ | 4.5×10⁻⁶ | 3.5×10⁻⁶ | 3.8×10⁻⁶ | 4.1×10⁻⁶ |
| | Adhesion | A | A | A | A | A |

**[Table 3]**

| | Details of materials | Example 1-11 | Example 1-12 | Example 1-13 | Example 1-14 | Example 1-15 |
|---|---|---|---|---|---|---|
| Silver nanoparticle (part(s) by mass) | 25nm | - | - | - | - | - |
| | 30nm | - | - | - | - | - |
| | 70nm | 40 | - | - | 20 | - |
| | 350nm | - | 40 | - | - | 30 |
| | 600nm | - | - | 40 | - | - |
| | 700nm | - | - | - | - | - |
| Silver particle (part(s) by mass) | 1.0*µ*m | 40 | - | - | 60 | - |
| | 3.0*µ*m | - | 40 | - | - | 50 |
| | 5.0*µ*m | - | - | 40 | - | - |
| First resin (part(s) by mass) | Bisphenol A type epoxy resin | 0.05 | - | - | - | - |
| | Bisphenol F type epoxy resin | - | 4.5 | - | - | - |
| | Aliphatic epoxy resin | - | - | 4.8 | - | - |
| | Novolac type epoxy resin | - | - | - | 2.7 | 4.1 |
| | Phenolic resin | - | - | | | |
| | Urethane resin | - | - | - | - | - |
| Curing agent (part(s) by mass) | Dicyandiamide | - | - | 1.2 | - | - |
| | Imidazole | 0.05 | 1.5 | - | 1.3 | 1.4 |
| | Hexamethylenetetramine | - | - | - | - | - |
| | Polvisocvanate | - | - | - | - | - |
| Second resin (part(s) by mass) | Hydroxyethylmethylcellulose | 0.1 | - | 4 | - | - |
| | Ethyl cellulose | - | 2 | - | - | 3 |
| | Ethyl cellulose acrylic polymer | - | - | - | 2 | - |
| | Polyamide | - | - | - | - | - |
| | Acrylic resin | - | - | - | - | - |
| Organic solvent (part(s) by mass) | Terpineol | 19.9 | - | - | 16 | - |
| | Diethylene glycol monoethyl ether acetate | - | 12 | - | - | 11.5 |
| | Texanol | - | - | 10 | - | - |
| Characteristics | Specific resistance (Ω·cm) | 2.5×10⁻⁶ | 4.9×10⁻⁶ | 4.5×10⁻⁶ | 4.9×10⁻⁶ | 4.1×10⁻⁶ |
| | Adhesion | A | A | A | A | A |

**[Table 4]**

| | Details of materials | Example 1-16 | Example 1-17 | Example 1-18 | Example 1-19 | Example 1-20 |
|---|---|---|---|---|---|---|
| Silver nanoparticle (part(s) by mass) | 25nm | - | - | - | - | - |
| | 30nm | - | - | - | 10 | 35 |
| | 70nm | - | 55 | - | - | - |
| | 350nm | - | - | 65 | - | - |
| | 600nm | 50 | - | - | - | - |
| | 700nm | - | - | - | - | - |
| Silver particle (part(s) by mass) | 1.0*µ*m | - | - | 20 | 70 | 45 |
| | 3.0*µ*m | - | 20 | - | - | - |
| | 5.0*µ*m | 30 | - | - | - | - |
| First resin (part(s) by mass) | Bisphenol A type epoxy resin | - | - | 1 | - | - |
| | Bisphenol F type epoxy resin | - | 3.3 | - | 0.15 | - |
| | Aliphatic epoxy resin | 2 | - | - | - | - |
| | Novolac type epoxy resin | - | - | - | - | 0.5 |
| | Phenolic resin | - | - | - | - | - |
| | Urethane resin | - | - | - | - | - |
| Curing agent (part(s) by mass) | Dicyandiamide | - | 1.7 | 1 | - | - |
| | Imidazole | 2 | - | - | 0.15 | 0.5 |
| | Hexamethylenetetramine | - | - | - | - | - |
| | Polvisocvanate | | | - | | |
| Second resin (part(s) by mass) | Hydroxyethylmethylcellulose | - | - | - | - | - |
| | Ethyl cellulose | - | - | 2 | 1 | 1 |
| | Ethyl cellulose acrylic polymer | 1.5 | 1 | 1 | - | - |
| | Polyamide | - | - | - | - | - |
| | Acrylic resin | - | - | - | - | - |
| Organic solvent (part(s) by mass) | Terpineol | - | 19 | 10 | - | - |
| | Diethylene glycol monoethyl ether acetate | - | - | - | - | - |
| | Texanol | 14.5 | - | - | 18.7 | 18 |
| Characteristics | Specific resistance (Ω·cm) | 4.1×10⁻⁶ | 4.5×10⁻⁶ | 3.5×10⁻⁶ | 3.2×10⁻⁶ | 3.1×10⁻⁶ |
| | Adhesion | A | A | A | A | A |

**[Table 5]**

| | Details of materials | Comparative Example 1-1 | Comparative Example 1-2 | Comparative Example 1-3 | Comparative Example 1-4 |
|---|---|---|---|---|---|
| Silver nanoparticle (part(s) by mass) | 25nm | - | 20 | - | - |
| | 30nm | - | - | - | - |
| | 70nm | - | - | 40 | - |
| | 350nm | - | - | - | 20 |
| | 600nm | - | - | - | - |
| | 700nm | 20 | - | - | - |
| Silver particle (part(s) by mass) | 1.0*µ*m | 60 | 60 | 40 | - |
| | 3.0*µ* m | - | - | - | 60 |
| | 5.0*µ* m | - | - | - | - |
| First resin (part(s) by mass) | Bisphenol A type epoxy resin | - | - | - | - |
| | Bisphenol F type epoxy resin | - | - | - | - |
| | Aliphatic epoxy resin | 1 | 1 | - | - |
| | Novolac type epoxy resin | - | - | - | - |
| | Phenolic resin | - | - | 2 | - |
| | Urethane resin | - | - | - | 2 |
| Curing agent (part(s) by mass) | Dicyandiamide | - | - | - | - |
| | Imidazole | 0.25 | 0.25 | - | - |
| | Hexamethylenetetramine | - | - | 2 | - |
| | Polvisocvanate | - | - | - | 2 |
| Second resin (part(s) by mass) | Hydroxyethylmethylcellulose | 1 | 1 | 1 | - |
| | Ethyl cellulose | - | - | - | 1 |
| | Ethyl cellulose acrylic polymer | - | - | - | - |
| | Polyamide | - | - | - | - |
| | Acrylic resin | - | - | - | - |
| Organic solvent (part(s) by mass) | Terpineol | - | | - | - |
| | Diethylene glycol monoethyl ether acetate | 18.75 | 18.75 | 16 | - |
| | Texanol | - | | - | 16 |
| Characteristics | Specific resistance (Ω·cm) | 2.1×10⁻⁵ | 1.6×10⁻⁵ | 3.9×10⁻⁵ | 3.4×10⁻⁵ |
| | Adhesion | B | A | B | A |

**[Table 6]**

| | Details of materials | Comparative Example 1-5 | Comparative Example 1-6 | Comparative Example 1-7 | Comparative Example 1-8 |
|---|---|---|---|---|---|
| Silver nanoparticle (part(s) by mass) | 25nm | - | - | - | - |
| | 30nm | - | - | - | - |
| | 70nm | - | - | - | - |
| | 350nm | 30 | 30 | - | - |
| | 600nm | - | - | 40 | 40 |
| | 700nm | - | - | - | - |
| Silver particle (part(s) by mass) | 1.0*µ*m | - | - | - | - |
| | 3.0*µ* m | - | - | - | - |
| | 5.0*µ* m | 50 | 50 | 40 | 40 |
| First resin (part(s) by mass) | Bisphenol A type epoxy resin | - | - | - | - |
| | Bisphenol F type epoxy resin | - | - | - | - |
| | Aliphatic epoxy resin | 2 | 2 | 2 | 2 |
| | Novolac type epoxy resin | - | - | - | - |
| | Phenolic resin | - | - | - | - |
| | Urethane resin | - | - | - | - |
| Curing agent (part(s) by mass) | Dicyandiamide | - | - | - | - |
| | Imidazole | 1 | 1 | 1 | 1 |
| | Hexamethylenetetramine | - | - | - | - |
| | Polvisocvanate | - | - | - | - |
| Second resin (part(s) by mass) | Hydroxyethylmethylcellulose | - | - | - | - |
| | Ethyl cellulose | - | - | - | - |
| | Ethyl cellulose acrylic polymer | - | - | - | - |
| | Polyamide | 3 | 1 | - | - |
| | Acrylic resin | - | - | 3 | 1 |
| Organic solvent (part(s) by mass) | Terpineol | - | | | |
| | Diethylene glycol monoethyl ether acetate | 17 | 17 | - | - |
| | Texanol | - | - | 17 | 17 |
| Characteristics | Specific resistance (Ω·cm) | 7.7×10⁻⁵ | 8.1×10⁻⁶ | 5.6×10⁻⁵ | 7.7×10⁻⁶ |
| | Adhesion | A | B | A | A |

As indicated in Table 1 to Table 4, in the printed wiring boards formed of the conductive pastes of Examples 1-1 to 1-20, the specific resistance of the wiring is small, and the adhesion of the wiring to the substrate is also excellent. On the other hand, as indicated in Table 5 and Table 6, in the printed wiring boards formed of the conductive pastes of Comparative Examples 1-1 to 1-8, the specific resistance of the wiring is large, or the adhesion of the wiring to the substrate is not excellent.

### (Example 2-1)

The conductive paste obtained in Example 1-1 was applied onto a substrate of a polyimide film by a screen printing method so as to have a pattern illustrated in FIG. 1 or 2, and calcined in an oven at 140°C or higher for 30 minutes or more to obtain a printed wiring board.

### (Comparative Example 2-1)

A printed wiring board was obtained in the same manner as in Example 2-1 except that CE-I-WB (150) manufactured by Tanaka Kikinzoku Kogyo was used as the conductive paste.

### (Comparative Example 2-2)

A printed wiring board was obtained in the same manner as in Example 2-1 except that Picosil (registered trademark) DNS-0201P manufactured by Daicel Corporation was used as the conductive paste.

### (Comparative Example 2-3)

A printed wiring board was obtained in the same manner as in Example 2-1 except that UNIMEC (registered trademark) H9481 manufactured by Namics was used as the conductive paste.

### [Evaluation]

### (Welding strength)

A chip resistor (1608 mm size) and a capacitive proximity detector (MTCH101 manufactured by Microchip) were mounted on the printed wiring board with the pattern illustrated in FIG. 1 at 170°C with a conductive bonding material (SAM10-401-27 manufactured by Tamura Corporation) of low-temperature bonding type. Then, using a universal bond tester (SERIES4000 manufactured by Nordson DAGE), a shear test was performed at a moving speed of 6 mm/min to measure the welding strength of the above electronic component to the substrate.

### (Film thickness)

In the printed wiring board with the pattern illustrated in FIG. 2, the film thickness of the wiring was measured using a stylus type profiler D500 manufactured by KLA-Tencor Corporation.

FIG. 2 is a plan view illustrating the printed wiring boards produced in the example and the comparative example. As illustrated in FIG. 2, in a pattern 1, a conductor pattern having a length of 300 mm and a width of 6 mm is formed. In a pattern 2, a conductor pattern having a length of 300 mm and a width of 3 mm is formed. In a pattern 3, a conductor pattern having a length of 300 mm and a width of 1 mm is formed. In a pattern 4, a conductor pattern having a length of 300 mm and a width of 0.5 mm is formed. In a pattern 5, a conductor pattern having a length of 300 mm and a width of 0.3 mm is formed.

### (Resistance value)

In a printed wiring board in which wiring was formed so as to have the pattern illustrated in FIG. 2, the resistance value of the wiring was measured using a digital multimeter manufactured by Advantest Corporation.

**[Table 7]**

| | | Example 2-1 | Comparative Example 2-1 | Comparative Example 2-2 | Comparative Example 2-3 |
|---|---|---|---|---|---|
| Welding strength (N) | Chip resistor | 112.5 | 4.1 | 5.8 | 18.6 |
| | Capacitive proximity detector | 156.3 | 11.2 | 8.3 | 23.1 |
| Pattern 1 | Film thickness (µm) | 23.5 | 6.3 | 4.6 | 16.8 |
| | Resistance value (mΩ/m) | 223.8 | 881.0 | 2845.3 | 501.3 |
| Pattern 2 | Film thickness (µm) | 25.4 | 7.3 | 5.9 | 17.2 |
| | Resistance value (mΩ/m) | 408.3 | 1572.3 | 4721.5 | 1023.5 |
| Pattern 3 | Film thickness (µm) | 26.7 | 8.9 | 6.6 | 18.6 |
| | Resistance value (mΩ/m) | 1154.6 | 3881.9 | 11884.4 | 2697.1 |
| Pattern 4 | Film thickness (µm) | 23.3 | 8.2 | 6.3 | 17.3 |
| | Resistance value (mΩ/m) | 2667.1 | 8102.7 | 24485.4 | 5778.6 |
| Pattern 5 | Film thickness (µm) | 22.6 | 7.6 | 5.7 | 15.9 |
| | Resistance value (mΩ/m) | 4536.8 | 14489.1 | 45130.7 | 10309.4 |

As illustrated in Table 7, in the printed wiring board according to Example 2-1, the welding strength of the chip resistor and the capacitive proximity detector to the substrate was 30 N or more. On the other hand, in the printed wiring boards according to Comparative Examples 2-1 to 2-3, the welding strength of the chip resistor and the capacitive proximity detector to the substrate was less than 30 N.

In the printed wiring board according to Example 2-1, the resistance value of the wiring was 5000 mQ/m or less. Therefore, in the printed wiring board according to Example 2-1, it is estimated that an amount of generated heat is 10°C or lower even when a current of 1 A is passed through the wiring. On the other hand, in the printed wiring boards according to Comparative Examples 2-1 to 2-3, the resistance value of the wiring exceeded 5000 mΩ/m. Therefore, in the printed wiring boards according to Comparative Examples 2-1 to 2-3, the amount of generated heat may increase when the amount of current flowing through the wiring increases as compared with the printed wiring board according to Example 2-1.

As described above, although the present embodiment has been demonstrated, the present disclosure is not limited thereto, and various modifications are possible within the range of the gist of the present embodiment.

## Claims

1. A printed circuit board comprising:
a substrate;
wiring provided on a surface of the substrate and including a cured conductive paste containing metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin; and
an electronic component connected to the substrate via the wiring,
wherein the wiring has a width of 0.3 mm or more and 6 mm or less, a thickness of 10 µm or more and 40 µm or less, and a resistance value of 500 mΩ/m or more and 5000 mQ/m or less, and
a welding strength of the electronic component to the substrate is 30 N or more.

2. The printed circuit board according to claim 1, wherein the thermosetting resin having the oxirane ring in the molecule is at least one selected from the group consisting of a bisphenol A type epoxy resin, a bisphenol F type epoxy resin, a novolac type epoxy resin, a glycidylamine type epoxy resin, and an aliphatic type epoxy resin.

3. The printed circuit board according to claim 1 or 2, wherein the average particle diameter of the metal particles is 1 µm or more and 5 µm or less.

4. The printed circuit board according to any one of claims 1 to 3, wherein the wiring is provided on both surfaces of the substrate.

5. The printed circuit board according to any one of claims 1 to 4, wherein the substrate has a curved surface, and the wiring is provided on the curved surface.

6. A method of manufacturing a printed circuit board, comprising:
applying a conductive paste to a surface of a substrate; and
curing the applied conductive paste to form wiring,
wherein the conductive paste contains metal nanoparticles having an average particle diameter of 30 nm or more and 600 nm or less, metal particles having an average particle diameter larger than that of the metal nanoparticles, a thermosetting resin having an oxirane ring in a molecule, a curing agent, and a cellulose resin,
the wiring has a width of 0.3 mm or more and 6 mm or less, a thickness of 10 µm or more and 40 µm or less, and a resistance value of 500 mQ/m or more and 5000 mQ/m or less, and
a welding strength of the electronic component to the substrate is 30 N or more.
